# EUROPÄISCHE PATENTSCHRIFT

(11) **EP 1 423 869 B1**
(45) Veröffentlichungstag und Bekanntmachung des Hinweises auf die Patenterteilung: **31.05.2006**
(21) Anmeldenummer: 02764782.5
(22) Anmeldetag: 26.07.2002
(51) Int. Cl.: H01L 21/316

(54) **VERFAHREN ZUR THERMISCHEN BEHANDLUNG EINES MEHRERE SCHICHTEN AUFWEISENDEN SUBSTRATS**
METHOD FOR THERMALLY TREATING A SUBSTRATE THAT COMPRISES SEVERAL LAYERS
PROCEDE DE TRAITEMENT THERMIQUE D'UN SUBSTRAT PRESENTANT PLUSIEURS COUCHES

(30) Priorität: 20.08.2001 DE 10140791
(43) Veröffentlichungstag der Anmeldung: 02.06.2004
(73) Patentinhaber: Mattson Thermal Products GmbH, 89160 Dornstadt (DE)
(72) Erfinder: CHUNG, Hin, Yiu, 89275 Elchingen (DE); ROTERS, Georg, 48249 Dülmen (DE)
(74) Vertreter: Wagner & Geyer
(86) Internationale Anmeldenummer: PCT/EP2002/008310
(87) Internationale Veröffentlichungsnummer: WO 2003/019625

(56) Entgegenhaltungen:
- US-A- 5 872 031
- US-A- 6 014 400
- CHOE J-S ET AL: "LATERAL OXIDATION OF ALAS LAYERS AT ELEVATED WATER VAPOUR PRESSURE USING A CLOSED-CHAMBER SYSTEM" SEMICONDUCTOR SCIENCE AND TECHNOLOGY, INSTITUTE OF PHYSICS. LONDON, GB, Bd. 15, Nr. 10, Oktober 2000 (2000-10), Seiten L35-L38, XP000976065 ISSN: 0268-1242

## Beschreibung

Die vorliegende Erfindung bezieht sich auf die thermische Behandlung eines mehrere Schichten aufweisenden Substrats, bei der eine von oben und unten abgedeckte Schicht des Substrats von dessen Seitenkanten aus zur Mitte hin oxidiert wird.

Ein derartiges Verfahren ist beispielsweise bei der Herstellung einer Blende für Oberflächenemittierende Halbleiterlaser mit vertikalem Resonator, die auch als Vertical Cavity Surface Emitting Laser (VCSEL) bezeichnet werden, bekannt. Ein VCSEL ist ein Halbleiterlaser, bei dem sich die erzeugte Strahlung vertikal, d.h. in einer Richtung senkrecht zur Halbleiteroberfläche und einer p-n-Übergangsebene ausbreitet. Bei herkömmlichen Lasern erfolgt die Ausbreitung der Strahlung in einer Richtung parallel zur Halbleiteroberfläche und der p-n-Übergangsebene. VCSEL's werden als bevorzugte Lichtquellen für große parallele optische Verbindungsarchitekturen verwendet. Um eine Kopplung der VCSEL's mit optischen Fasern zu ermöglichen, müssen sie ein Gauss'sches Strahlenprofil emittieren. Für das Gauss'sche Strahlenprofil und für eine Laseraktivierung ist eine spezielle kreisförmige Blende in dem VCSEL notwendig, die genau definiert sein muß.

Diese Blende wurde in der Vergangenheit durch eine von der Seite her fortschreitende Oxidation von AlGaAs-Strukturen der VCSEL's gebildet. Für die Oxidation wurden die VCSELs in einer Prozeßkammer auf eine Behandlungstemperatur gebracht und mit einem stickstoffhaltigen Wasserdampf oxidiert. Nach der Oxidation wurden die VCSELs in der Prozeßkammer in einer inerten Gasatmosphäre auf eine Temperatur kleiner als die Prozeßtemperatur abgekühlt, und anschließend wurden sie aus der Prozeßkammer entnommen. Um den Durchsatz zu erhöhen werden bei manchen VCSEL-Prozesse die Substrate bereits bei Prozeßtemperaturen aus der Prozeßkammer entnommen, die Abkühlung der Substrate erfolgt dann in der Regel in Umgebungsluft.

Die seitliche Oxidation wird, wie es beispielsweise aus dem US-Patent 6,014,400 bekannt ist, durch die stickstoffhaltige Wasserdampfbehandlung eingeleitet, und es bildet sich eine von außen nach innen fortschreitende Oxidationsfront. Während der Abkühlung in inerten Gasatmosphäre und beim Entladen der Wafer aus der Prozeßkammer bzw. beim Abkühlen der VCSEL-Strukturen aufweisenden Substraten in Umgebungsluft wird ein Fortschreiten der Oxidation allmählich abgebremst und zum Stillstand gebracht. Dieses Abbremsen und Anhalten der Oxidationsfront läßt sich bei dem oben genannten Verfahren jedoch nicht genau steuern, so daß eine gute und vorhersagbare Blendenbildung nicht möglich ist.

Für gute optische Eigenschaften der VCSEL's, insbesondere zur Ausbildung eines gewünschten räumlichen Strahlungsprofils wie etwa einem Gauss'schen Strahlungsprofil ist jedoch eine genaue Blendenbildung notwendig.

Ausgehend von dem oben beschriebenen Stand der Technik liegt der vorliegenden Erfindung daher die Aufgabe zugrunde, ein Verfahren vorzusehen, bei dem eine seitlich fortschreitende Oxidation einer Schicht eines mehrschichtigen Substrats derart möglich ist, daß ein definierter Mittelbereich nicht oxidiert, d.h. daß ein Fortschreiten der seitlichen Oxidation an einem bestimmten Punkt gestoppt werden kann.

Erfindungsgemäß wird diese Aufgabe gelöst durch ein Verfahren zur thermischen Behandlung eines mehrere Schichten aufweisenden Substrats, insbesondere eines Halbleiterwafers, bei dem eine von oben und unten abgedeckte Schicht des Substrats von dessen Seitenkante aus zur Mitte hin derart oxidiert wird, daß ein definierter Mittelbereich nicht oxidiert, wobei das Substrat in einer Prozeßkammer auf eine vorgegebene Behandlungstemperatur erwärmt wird, ein wasserstoffreicher Wasserdampf für eine vorgegebene Zeitdauer in die Prozeßkammer eingeleitet wird, und nach Ablauf der vorgegebenen Zeitdauer trockener Sauerstoff oder ein sauerstoffreicher Wasserdampf in die Prozeßkammer eingeleitet wird. Durch Erwärmen des Substrats auf die Behandlungstemperatur und Einleiten eines wasserstoffreichen Wasserdampfes läßt sich eine kontrollierte, seitlich fortschreitende Oxidation einer von oben und unten abgedeckten Schicht des Substrats erreichen. Durch anschließendes Einleiten von trockenem Sauerstoff oder einem sauerstoffreichen Wasserdampf in die Prozeßkammer läßt sich das seitliche Fortschreiten der Oxidation definiert stoppen, um einen definierten, nicht oxidierten Mittelbereich zu erhalten. Trockener Sauerstoff umfaßt sowohl reinen Sauerstoff (in Form von atomarem O und/oder molekularem O₂ und/oder O₃) wie auch ein Gemisch aus Sauerstoff und einem inerten Gas wie beispielsweise Stickstoff oder Argon, wobei sich das inerte Gas dadurch auszeichnet, daß es nicht mit den Schichten des Substrats chemisch reagiert. Ferner umfaßt trockener Sauerstoff auch sauerstoffenthaltende Verbindungen welche kein Wasser enthalten.

Bei einer bevorzugten Ausführungsform der Erfindung wird zwischen dem Einleiten des wasserstoffreichen Wasserdampfs und dem Einleiten des trokkenen Sauerstoffs oder des sauerstoffreichen Wasserdampfs ein weiteres Gas in die Prozeßkammer eingeleitet, um den wasserstoffreichen Wasserdampf aus der Prozeßkammer zu verdrängen. Hierdurch wird verhindert, daß sich in der Prozeßkammer ein Knallgas aus Wasserstoff und Sauerstoff bildet, was aufgrund der erhöhten Temperatur der Prozeßkammer und des Substrats zu einer Explosionsgefahr führen könnte. Dabei weist das weitere Gas weder Wasserstoff noch Sauerstoff auf. Vorzugsweise ist das weitere Gas ein inertes Gas, um unerwünschte Reaktionen mit dem Substrat während dieses Spülschritts zu vermeiden.

Für eine gute und steuerbare, seitlich fortschreitende Oxidation der zu oxidierenden Schicht wird das Substrat vorzugsweise auf eine Behandlungstemperatur zwischen 300 °C bis 700 °C erwärmt.

Bei einer besonders bevorzugten Ausführungsform der Erfindung weist das Substrat einen Halbleiterwafer mit einer AlGaAs-Struktur auf, die beispielsweise für die Bildung eines VCSEL's geeignet ist. Dabei ist die zu oxidierende Schicht vorzugsweise eine Aluminium enthaltende Schicht (kurz im folgenden als Aluminiumschicht bezeichnet). Bei der Aluminiumschicht wird während des Einleitens des trockenen Sauerstoffs oder des sauerstoffreichen Wasserdampfs Saphir gebildet, was das seitliche Fortschreiten der Oxidationsfront unterdrückt.

Vorteilhafterweise bilden wenigstens einige der Vielzahl von Schichten einen vorzugsweise runden Kegelstumpf, wobei die zu oxidierende Schicht im Bereich des Kegelstumpfs liegt. Hierdurch läßt sich ein gut definierter runder, nicht oxidierter Mittelbereich der zu oxidierenden Schicht erreichen.

Gemäß der bevorzugten Ausführungsform der Erfindung bildet der nicht oxidierte Mittelbereich der zu oxidierenden Schicht eine Blende für einen Vertical Cavity Surface Emitting Laser (VCSEL). Dabei ist die Blende vorzugsweise rund, um eine gute Aktivierung des Lasers und ein Gauss'sches Abstrahlprofil zu erreichen.

Vorzugsweise wird die Temperatur des Substrats während des Einleitens des wasserstoffreichen Wasserdampfs und des trockenen Sauerstoffs oder des sauerstoffreichen Wasserdampfs auf der Behandlungstemperatur gehalten, um ein definiertes Fortschreiten der Oxidationsfront und ein kontrolliertes Stoppen der Oxidationsfront zu ermöglichen. Für eine Beschleunigung des Verfahrens wird das Substrat vorzugsweise direkt nach dem Schritt c) aus der Prozeßkammer entfernt, was möglich ist, da die Oxidationsfront durch das Einleiten des trockenen Sauerstoffs bzw. des sauerstoffreichen Wasserdampfs kontrolliert gestoppt wurde. Ein kontrolliertes Abkühlen des Substrats in der Prozeßkammer ist daher nicht mehr notwendig.

Das Einleiten des wasserstoffreichen Wasserdampfs kann vor, während und/oder nach dem Erwärmen des Substrats auf die vorgegebene Behandlungstemperatur erfolgen, wobei bei thermischen Behandlungen in Schnellheizanlagen (RTP-Anlagen) die Einleitung jedoch vorteilhafterweise vor der Erwärmung erfolgt, um möglichst genau definierte Bedingungen für die seitlich fortschreitende Oxidation vorzusehen.

Die Erfindung wird nachfolgend anhand eines bevorzugten Ausführungsbeispiels der Erfindung unter Bezugnahme auf die Zeichnung näher erläutert. In der Zeichnung zeigt:
- Fig. 1: eine Schnittansicht einer AlGaAs-Halbleiterstruktur für einen Vertical Cavity Surface Emitting Laser (VCSEL);
- Fig. 2: eine schematische Schnittdarstellung durch einen Brenner zum Vorsehen eines wasserstoff- bzw. sauerstoffhaltigen Wasserdampfs;
- Fig. 3: ein schematisches Blockdiagramm einer Substratbehandlungsvorrichtung zur Durchführung des erfindungsgemäßen Verfahrens.

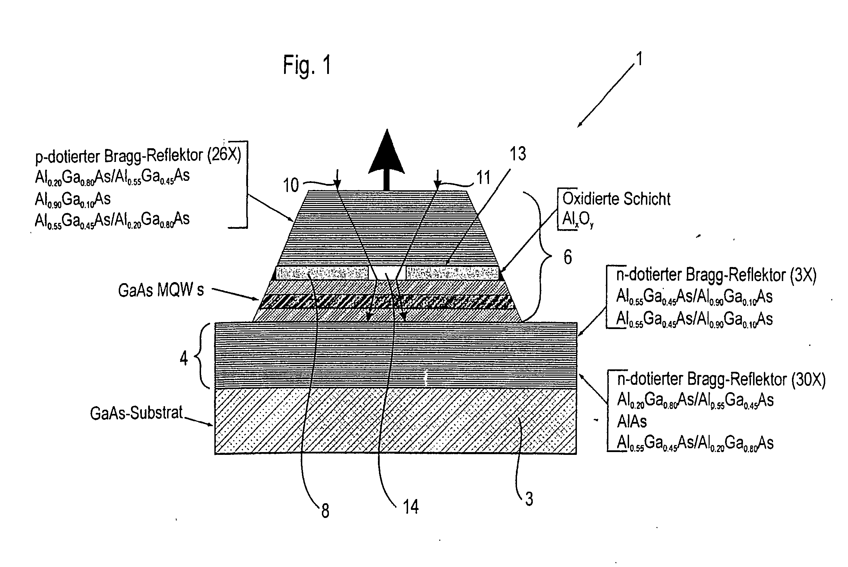

Fig. 1 zeigt eine schematische Schnittansicht durch den Aufbau einer AlGaAs-Struktur für einen Vertical Cavity Surface Emitting Laser 1, dessen Lichtaustrittsblende gemäß dem erfindungsgemäßen Verfahren hergestellt ist.

Der Laser weist ein GaAs-Substrat auf, auf dem eine erste Vielzahl von n-dotierten AlGaAs-Schichten aufgebracht ist. Die erste Vielzahl von Schichten ist in einem Bereich 4 auf dem GaAs-Substrat aufgebracht, und die Schichten besitzen im wesentlichen dieselben Umfangsabmessungen wie das GaAs-Substrat 3. Über den Bereich 4 hinweg verändern sich die Dotierungen der Schichten, wie in Fig. 1 angedeutet ist.

In einem weiteren Abschnitt 6 wird eine zweite Vielzahl von Schichten auf der ersten Vielzahl von Schichten aufgebracht. Im zweiten Abschnitt 6 werden die Vielzahl von Schichten derart aufgebracht bzw. so prozessiert, daß sie einen runden Kegelstumpf oder einen Mesa bilden, d.h., eine über das Substrat erhabene Schichtstrucktur.

Benachbart zum Abschnitt 4 mit der ersten Vielzahl von Schichten sind zunächst GaAsMQW-Schichten vorgesehen. Anschließend folgt eine Aluminiumschicht 8, auf der dann eine Vielzahl von p-dotierten AlGaAs-Schichten vorgesehen ist. Auf der Oberseite des Kegelstumpfs sind elektrische Anschlüsse für die Aktivierung des Lasers vorgesehen, wie durch die Pfeile 10, 11 dargestellt ist.

Die Aluminiumschicht 8 besitzt einen dunkel dargestellten oxidierten Außenbereich 13, sowie einen hell dargestellten nicht oxidierten Mittelbereich 14, der als Blende für den Laser dient. Für eine gute Laseraktivierung, und für eine gute Kopplung des Lasers an optische Fasern ist es wichtig, daß der nicht oxidierte Mittelbereich 14 eine möglichst genau definierte runde Blende bildet.

Eine derartige, genau definierte runde Blende läßt sich durch das nachfolgend beschriebene erfindungsgemäße Verfahren herstellen.

Zur Bildung des oxidierten Außenbereichs 13 wird eine AlGaAs-Struktur mit dem obigen Aufbau, bei der die Aluminiumschicht 8 in einem durchgehend nicht oxidierten Zustand vorliegt, in eine Prozeßkammer einer thermischen Behandlungsanlage geladen. Die thermische Behandlungsanlage ist beispielsweise eine Schnellheizanlage, wie sie aus der auf dieselbe Anmelderin zurückgehenden DE-A-199 05 524 bekannt ist, die insofern zum Gegenstand der vorliegenden Erfindung gemacht wird, um Wiederholungen zu vermeiden.

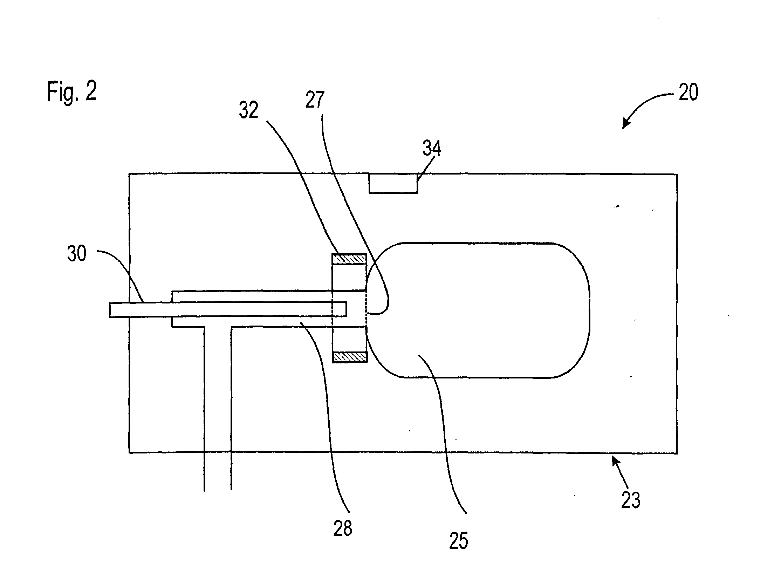

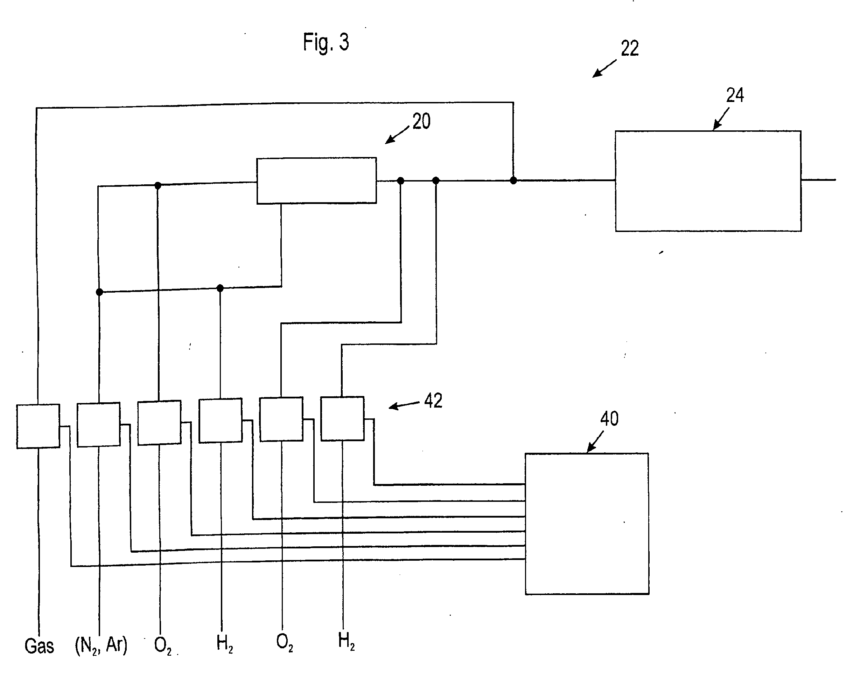

Anschließend wird die Temperatur der AlGaAs-Struktur auf eine Behandlungstemperatur zwischen 300 und 700 °C erwärmt, die für eine gute und definierte Oxidation der Aluminiumschicht 8 vorteilhaft ist. Nach der Erwärmung der Struktur wird ein wasserstoffreicher Wasserdampf in die Prozeßkammer der Heizanlage eingeleitet. Der wasserstoffreiche Wasserdampf kann beispielsweise erzeugt werden, indem Wasserstoff durch Wasserdampf hindurch geleitet wird. Alternativ kann die wasserstoffreiche Wasserdampfmischung auch durch den nachfolgend unter Bezugnahme auf die Figuren 2 und 3 beschriebenen Brenner erzeugt werden.

Durch das Einleiten des wasserstoffreichen Wasserdampfs kommt es zu den folgenden chemischen Reaktionen innerhalb der Prozeßkammer:

2AlAs + 3H₂O = Al₂O₃ + 2AsH₃

AIAs + 2H₂O = AIO(OH) + AsH₃

AIO(OH) + AIAs + H₂O = Al₂O₃ + 2AsH₃

AIAs + 3H₂O = AI(OH)₃ + AsH₃

AI(OH)₃ + AIAs = Al₂O₃ + AsH₃

2AIAs + 6H₂O = Al₂O₃ + As₂O₃ + 6H₂

As₂O₃ + 6H₂ = 2AsH₃ + 3H₂O

Dabei kommt es zu einer seitlich verlaufenden Oxidation der Aluminiumschicht, die von Seitenkanten der Schicht 8 her nach innen fortschreitet. Die seitliche Geschwindigkeit der Oxidation ist bekannt, und nach Erreichen eines bestimmten Fortschritts der Oxidation, d.h. nach Ablauf einer bestimmten Zeitperiode wird das Einleiten des wasserstoffreichen Wasserdampfs gestoppt.

Anschließend wird die Prozeßkammer mit einem Gas, vorzugsweise einem inerten Gas, gespült, um den Wasserstoff aus der Prozeßkammer auszutreiben. Als inerte Gase werden vorzugsweise Stickstoff und/oder Edelgase wie z.B. Argon verwendet.

Nach der Spülung der-Prozeßkammer mit dem inerten Gas wird trockener Sauerstoff oder sauerstoffreicher Wasserdampf in die Prozeßkammer eingeleitet. Durch das Einleiten des trockenen Sauerstoffes oder des sauerstoffreichen Wasserdampfes kommt es zu folgender chemischer Reaktion:

4AlAs + 5O₂ = 2Al₂O₃ + 4AsO bzw.

2AlAs + 3O₂ = Al₂O₃ + As₂O₃

Hierdurch wird ein Fortschreiten der Oxidationsfront durch Passivierung der Oxidschicht erreicht. Somit kann das Fortschreiten der Oxidationsfront und die Bildung der nicht oxidierten Blende 14 genau gesteuert werden, um einen definierten Randbereich der Blende für den Laser zu bilden.

Statt des oben beschriebenen Spülschritts mit einem inerten Gas ist es auch möglich, zur Spülung der Prozeßkammer ein anderes Gas oder z.B. reinen Wasserdampf in die Prozeßkammer einzuleiten, um nach dem Austreiben des wasserstoffreichen Wasserdampfs den trockenen Sauerstoff oder sauerstoffreichen Wasserdanpf einzuleiten. Das Austreiben des Wasserstoffs vor dem Einleiten von Sauerstoff ist notwendig, um die Bildung einer Knallgasmischung in der Prozeßkammer zu verhindern.

Der wasserstoffreiche Wasserdampf und/oder der sauerstoffreiche Wasserdampf kann mit einem Brenner 20 hergestellt werden, der schematisch im Schnitt in Figur 2 dargestellt ist. Figur 3 zeigt schematisch in Blockdiagrammform eine gesamte Anlage 22, die zur Durchführung des oben beschriebenen Verfahrens geeignet ist und die den Brenner 20 gemäß Figur 2 sowie eine thermische Behandlungseinheit 24 beinhaltet.

Der Brenner 20 und die Anlage 22 besitzen beispielsweise einen Aufbau, wie er in der auf dieselbe Anmelderin zurückgehenden, nicht vorveröffentlichten deutschen Patentanmeldung Nr. 101 19 741 mit dem Titel "Verfahren und Vorrichtung zum Erzeugen von Prozeßgasen" vom 23. April 2001 beschrieben ist, die in sofern zum Gegenstand der vorliegenden Erfindung gemacht wird, um Wiederholungen zu vermeiden.

Zusammenfassend weist der Brenner 20 ein Gehäuse 23 mit einer Brennkammer 25 auf. Die Brennkammer 25 weist einen Einlaß 27 auf, der mit ersten und zweiten Gaseinlaßleitungen 28, 30 in Verbindung steht. Über die Einlaßleitungen 28, 30 kann jeweils in kontrollierter Weise Sauerstoff oder Wasserstoff in die Brennkammer 25 eingeleitet werden. Im Bereich des Einlaß 27 ist ein die Einlaßleitungen 28, 30 umgebender Heizring 32 vorgesehen, um den über die Einlaßleitungen 28, 30 eingeleiteten Gase zu Erwärmen und eine Verbrennung der dabei entstehenden Knallgasmischung aus Wasserstoff und Sauerstoff zu bewirken. Die Verbrennung wird mit einem entsprechenden Flammsensor 34 überwacht. Bei der Verbrennung entsteht Wasserdampf durch stöchiometrische Verbrennung von Bestandteilen der entstehenden Sauerstoff/Wasserstoff-Gasmischung. Wenn einer der Bestandteile oberhalb eines stöchiometrischen Verhältnisses vorliegt ergibt sich eine sauerstoffreiche bzw. wasserstoffreiche Wasserdampfmischung, die für eine thermische Behandlung des VCSEL 1 in die thermische Behandlungseinheit 24 gemäß Figur 3 geleitet werden kann.

Durch Erhöhen des Sauerstoff- oder Wasserstoffgehalts kann zwischen einer sauerstoffreichen und einer wasserstoffreichen Wasserdampfmischung gewechselt werden, wobei bei dem Wechsel zu beachten ist, daß außerhalb des Brenners keine Knallgasmischung entstehen darf. Dies kann beispielsweise dadurch erreicht werden, daß beispielsweise nach der Erzeugung einer sauerstoffreichen Wasserdampfmischung für eine bestimmte Zeitperiode stöchiometrische Verhältnisse von Sauerstoff und Wasserstoff in den Brenner eingeleitet werden, um eine vollständige Verbrennung sicherzustellen und den überschüssigen Sauerstoff aus dem Brenner auszutreiben. Erst anschließend wird zusätzlicher Wasserstoff in den Brenner eingeleitet, um nunmehr eine wasserstoffreiche Wasserdampfmischung zu erzeugen.

Alternativ kann der Brenner natürlich auch zwischenzeitig mit einem inerten Gas gespült werden, das auch gleichzeitig für die Spülung der thermischen Behandlungseinheit 24 verwendet werden kann.

Wie in Figur 3 zu erkennen ist, weist die Gesamtanlage 22, die für das thermische Behandlungverfahren der vorliegenden Erfindung eingesetzt werden kann, eine Steuereinheit 40 auf, die über entsprechende Ventile 42 die Zuleitung unterschiedlicher Gase in den Brenner 20 bzw. eine Verbindungsleitung zwischen dem Brenner 20 und der thermischen Behandlungseinheit 24 steuert. Durch Einleiten von Sauerstoff oder Wasserstoff in eine Verbindungsleitung zwischen dem Brenner 20 und der thermischen Behandlungseinheit 24 ist es möglich, den Sauerstoff- bzw. Wasserstoffgehalt der sauerstoffreichen bzw. wasserstoffreichen Wasserdampfmischung genau einzustellen.

Die Erfindung wurde zuvor anhand bevorzugter Ausführungsbeispiele beschrieben, ohne auf die konkret dargestellten Ausführungsbeispiele beschränkt zu sein. Beispielsweise ist für die Erzeugung einer sauerstoffreichen bzw. wasserstoffreichen Wasserdampfmischung nicht die Verwendung eines Brenners gemäß Figur 2 notwendig. Vielmehr könnte die Mischung auch durch Verdampfen von Wasser und Einleiten von Sauerstoff oder Wasserstoff in den Dampf erzeugt werden. Weiterhin läßt sich das erfindungsgemäße Verfahren zur Behandlung eines mehrere Schichten aufweisenden Substrats bei beliebigen Prozeßkammerdrücken durchführen. Beispielsweise läßt sich das Verfahren in RTP-Anlagen bei Normaldruck (Atmosphärendruck), Überdruck oder Unterdruck durchführen. Bei geeignetem Unterdruck und Kammerauslegung läßt sich ein etwaiger Explosionsdruck einer etwaigen Knallgasexplosion soweit reduzieren, daß keine Kammer- bzw. Substratbeschädigung erfolgt. Damit wird ein direktes Umschalten zwischen wasserstoffreichem und sauerstoffreichem Wasserdampf (oder umgekehrt) möglich, ohne daß die Kammer durch ein inertes Gas oder reinen Wasserdampf zur Vermeidung einer Knallgasmischung gespült wird.

## Patentansprüche

1. Verfahren zur thermischen Behandlung eines mehrere Schichten aufweisenden Substrats, insbesondere eines Halbleiterwafers, bei dem eine von oben und unten abgedeckte Schicht des Substrats von dessen Seitenkante aus zur Mitte hin derart oxidiert wird, daß ein definierter Mittelbereich nicht oxidiert, wobei die folgenden Verfahrensschritte vorgesehen sind:
a) Erwärmen des Substrats in einer Prozeßkammer auf eine vorgegebene Behandlungstemperatur;
b) Einleiten eines wasserstoffreichen Wasserdampfes in die Prozeßkammer für eine vorgegebene Zeitdauer;
c) Einleiten von trockenem Sauerstoff, d.h. reinem Sauerstoff (in Form von atomarem O und/oder molekularem O₂ und/oder O₃), eine Mischung aus Sauerstoff und einem inerten Gas, das nicht mit den Schichten des Substrats chemisch reagiert, oder einer sauerstoffenthaltende Verbindungen, welche kein Wasser enthält, oder einem sauerstoffreichen Wasserdampf in die Prozeßkammer nach Ablauf der vorgegebenen Zeitdauer,
wobei Schritt b) vor, während und/oder nach dem Erwärmen des Substrats auf die vorgegebene Behandlungstemperatur erfolgen kann.

2. Verfahren nach Anspruch 1, **dadurch gekennzeichnet, daß** zwischen den Schritten b) und c) ein weiteres Gas in die Prozeßkammer eingeleitet wird, um den wasserstoffreichen Wasserdampf aus der Prozeßkammer zu verdrängen.

3. Verfahren nach Anspruch 2, **dadurch gekennzeichnet, daß** das weitere Gas weder Wasserstoff noch Sauerstoff enthält.

4. Verfahren nach Anspruch 2 oder 3, **dadurch gekennzeichnet, daß** das weitere Gas ein inertes Gas ist.

5. Verfahren nach einem der vorhergehenden Ansprüche, **dadurch gekennzeichnet, daß** das Substrat auf eine Behandlungstemperatur zwischen 300 °C bis 700 °C erwärmt wird.

6. Verfahren nach einem der vorhergehenden Ansprüche, **dadurch gekennzeichnet, daß** das Substrat einen Halbleiterwafer mit einer III-V-Halbleiterstruktur, insbesondere einer AlGaAs-Struktur oder InAlAs-Struktur, aufweist.

7. Verfahren nach Anspruch 6, **dadurch gekennzeichnet, daß** die zu oxidierende Schicht eine Aluminium enthaltende Schicht ist.

8. Verfahren nach einem der vorhergehenden Ansprüche, **dadurch gekennzeichnet, daß** wenigstens einige der Vielzahl von Schichten einen Kegelstumpf bilden.

9. Verfahren nach Anspruch 8, **dadurch gekennzeichnet, daß** der Kegelstumpf rund ist.

10. Verfahren nach Anspruch 8 oder 9, **dadurch gekennzeichnet, daß** die zu oxidierende Schicht im Bereich des Kegelstumpfes liegt.

11. Verfahren nach einem der vorhergehenden Ansprüche, **dadurch gekennzeichnet, daß** der nicht oxidierte Mittelbereich der einen Schicht eine Blende für einen Oberflächenemittierenden Halbleiterlaser mit vertikalem Resonator, der auch als Vertical Cavity Surface Emitting Laser (VCSEL) bezeichnet wird, bildet.

12. Verfahren nach Anspruch 11, **dadurch gekennzeichnet, daß** die Blende rund ist.

13. Verfahren nach einem der vorhergehenden Ansprüche, **dadurch gekennzeichnet, daß** das Substrat während der Schritte b) und c) auf der Behandlungstemperatur gehalten wird.

14. Verfahren nach einem der vorhergehenden Ansprüche, **dadurch gekennzeichnet, daß** das Substrat direkt nach dem Schritt c) aus der Prozeßkammer entfernt wird.

15. Verfahren nach einem der vorhergehenden Ansprüche, **dadurch gekennzeichnet, daß** die Prozeßkammer bei Unterdruck betrieben wird.

## Claims

1. Method for the thermal treatment of a substrate, especially a semiconductor wafer, that has multiple layers, according to which a substrate layer that is covered from above and below is oxidized from the side edges thereof toward the center in such a way that a defined central portion is not oxidized, whereby the following method steps are provided:
a) Heating the substrate in a process chamber to a prescribed treatment temperature;
b) Introducing a hydrogen-rich water vapor into the process chamber for a specified period of time;
c) Introducing dry oxygen, i.e. pure oxygen (in the form of atomic O and/or molecular O₂ and/or O₃), a mixture of oxygen and an inert gas that does not chemically react with the layers of the substrate, or an oxygen-containing compound that contains no water, or oxygen-rich water vapor into the process chamber after conclusion of the specified period of time,
whereby step b) can be effected prior to, during and/or after the heating of the substrate to the prescribed treatment temperature.

2. Method according to claim 1, **characterized in that** between the steps b) and c) a further gas is introduced into the process chamber in order to displace the hydrogen-rich water vapor out of the process chamber.

3. Method according to claim 2, **characterized in that** the further gas contains neither hydrogen nor oxygen.

4. Method according to claim 2 or 3, **characterized in that** the further gas is an inert gas.

5. Method according to one of the preceding claims, **characterized in that** the substrate is heated to a treatment temperature of between 300°C and 700°C.

6. Method according to one of the preceding claims, **characterized in that** the substrate is provided with a semiconductor wafer having a III-V-semiconductor structure, especially an AlGaAs structure or InAlAS structure.

7. Method according to claim 6, **characterized in that** the layer that is to be oxidized is an aluminum-containing layer.

8. Method according to one of the preceding claims, **characterized in that** at least some of said plurality of layers forms a truncated cone.

9. Method according to claim 8, **characterized in that** the truncated cone is round.

10. Method according to claim 8 or 9, **characterized in that** the layer that is to be oxidized is disposed in the region of the truncated cone.

11. Method according to one of the preceding claims, **characterized in that** the not-oxidized central portion of the one layer forms an aperture for a surface-emitting semiconductor laser having a vertical resonator, which is also designated as Vertical Cavity Surface Emitting Laser (VCSEL).

12. Method according to claim 11, **characterized in that** the aperture is round.

13. Method according to one of the preceding claims, **characterized in that** the substrate is held to the treatment temperature during the steps b) and c).

14. Method according to one of the preceding claims, **characterized in that** the substrate is removed from the process chamber directly after the step c).

15. Method according to one of the preceding claims, **characterized in that** the process chamber is operated at underpressure.

## Revendications

1. Procédé de traitement thermique d'un substrat présentant plusieurs couches, en particulier d'une tranche de semi-conducteurs, dans lequel une couche du substrat recouverte en haut et en bas est oxydée à partir de son bord latéral en direction du centre, de façon qu'une zone médiane définie n'oxyde pas, les étapes suivantes du procédé étant prévues :
a) chauffage du substrat dans une chambre de traitement à une température de traitement prédéterminée ;
b) introduction d'une vapeur d'eau riche en hydrogène dans la chambre de traitement pendant une durée prédéterminée ;
c) introduction d'oxygène sec, c'est-à-dire d'oxygène pur (sous forme de O atomique et/ou de O₂ moléculaire et/ou de O₃), d'un mélange d'oxygène et d'un gaz inerte qui ne réagit pas chimiquement avec les couches du substrat, ou d'un composé contenant de l'oxygène, qui ne contient pas d'eau, ou d'une vapeur d'eau riche en oxygène dans la chambre de traitement après l'expiration de la durée prédéterminée,
l'étape b) pouvant avoir lieu avant, pendant et/ou après le chauffage du substrat à la température de traitement prédéterminée.

2. Procédé selon la revendication 1, **caractérisé en ce que**, entre les étapes b) et c), un autre gaz est introduit dans la chambre de traitement afin de refouler la vapeur d'eau riche en hydrogène hors de la chambre de traitement.

3. Procédé selon la revendication 2, **caractérisé en ce que** l'autre gaz ne contient ni hydrogène ni oxygène.

4. Procédé selon la revendication 2 ou 3, **caractérisé en ce que** l'autre gaz est un gaz inerte.

5. Procédé selon l'une des revendications précédentes, **caractérisé en ce que** le substrat est chauffé à une température de traitement entre 300°C et 700°C.

6. Procédé selon l'une des revendications précédentes, **caractérisé en ce que** le substrat présente une tranche de semi-conducteurs avec une structure de semi-conducteurs III-V, en particulier une structure AlGaAs ou une structure InAlAs.

7. Procédé selon la revendication 6, **caractérisé en ce que** la couche d'oxydation est une couche contenant de l'aluminium.

8. Procédé selon l'une des revendications précédentes, **caractérisé en ce qu'**au moins quelques-unes de la pluralité de couches forment un tronc de cône.

9. Procédé selon la revendication 8, **caractérisé en ce que** le tronc de cône est circulaire.

10. Procédé selon la revendication 8 ou 9, **caractérisé en ce que** la couche d'oxydation se situe dans la zone du tronc de cône.

11. Procédé selon l'une des revendications précédentes, **caractérisé en ce que** la zone médiane non oxydée d'une couche forme un diaphragme pour un laser semi-conducteur émettant par la surface, avec résonateur vertical, qui est désigné aussi par laser à cavité verticale à émission par la surface (VCSEL).

12. Procédé selon la revendication 11, **caractérisé en ce que** le diaphragme est circulaire.

13. Procédé selon l'une des revendications précédentes, **caractérisé en ce que** le substrat est maintenu à la température de traitement pendant les étapes b) et c).

14. Procédé selon l'une des revendications précédentes, **caractérisé en ce que** le substrat est retiré de la chambre de traitement directement après l'étape c).

15. Procédé selon l'une des revendications précédentes, **caractérisé en ce que** la chambre de traitement reste en dépression.
